# EUROPÄISCHE PATENTANMELDUNG

(11) **EP 1 251 592 A1**
(43) Veröffentlichungstag der Anmeldung: **23.10.2002**
(21) Anmeldenummer: 01811021.3
(22) Anmeldetag: 19.10.2001
(51) Int. Cl.: H01R 13/24, H05K 3/32

(54) **Vorrichtung zur Befestigung und Kontaktierung von Modulen elektrischer Geräte**

(30) Priorität: 21.04.2001 CH 7262001
(71) Anmelder: Ascom AG, 3000 Bern 14 (CH)
(72) Erfinder: Künzli, Daniel, 4513 Langendorf (CH)
(74) Vertreter: Rutz, Peter

(57) **Zusammenfassung**

Die Vorrichtung (1), die zur Befestigung und Kontaktierung von Modulen elektrischer Geräte dient, weist einen elastischen Körper (10) auf, der zwischen einer einem ersten Gehäuseteil (4) zugewandten Leiterplatte (3) und einem einem zweiten Gehäuseteil (6) zugewandten ersten Modul (5) installiert wird, so dass die Leiterplatte (3) und das erste Modul (5) nach dem Verbinden der beiden Gehäuseteile (4, 6) elastisch gehalten sind. Erfindungsgemäss wird ein Kontaktierungselement (11) zwischen den elastischen Körper (10) und die Leiterplatte (3) oder zwischen den elastischen Körper (10) und das erste Modul (5) eingefügt, welches Anschlusskontakte (31, 32, 33, ...; 51b) der Leiterplatte (3) oder des ersten Moduls (5) mit einem Anschlusskabel (12) verbindet. Mittels der Vorrichtung können Module (2, 3, 5) eines Gerätes daher in einfacher Weise montiert und miteinander elektrisch verbunden werden.

## Beschreibung

Die Erfindung betrifft eine Vorrichtung zur Befestigung und Kontaktierung von Modulen elektrischer Geräte, insbesondere von Kommunikationsendgeräten, nach dem Oberbegriff des Patentanspruchs 1.

Moderne Kommunikationsendgeräte, beispielsweise Mobilfunkendgeräte, bestehen üblicherweise nur noch aus wenigen in einem Gehäuse angeordneten Modulen, beispielsweise einer Stromversorgung, einer mit elektrischen Bauteilen bestückten Leiterplatte, einer Tastatur, einem Schalter, einer Anzeigeeinheit, und Schallwandlern, die elektrisch miteinander verbunden sind.

Die Anschlussleitungen der Schallwandler, eines Mikrofons und eines Lautsprechers, werden mit entsprechenden Anschlüssen der Leiterplatte normalerweise verlötet. Die Anzeigeeinheit, die Tastatur und der Schalter, der zum Ein- und Ausschalten oder zum Umschalten der Betriebsart des Gerätes dient, werden meist mittels Steckern mit der Leiterplatte verbunden.

Diese Vorgänge zur Montage und zum Verbinden der einzelnen Module innerhalb eines Gehäuses sind mit entsprechendem Aufwand verbunden. Bei hohen Stückzahlen sind ferner die Kosten für die Verbindungselemente zu beachten.

Zur Reduktion des Aufwandes zur Montage eines Mikrofons kann die in der Offenlegungsschrift EP 0 901 308 A2 beschriebene integrierte Halte- und Verbindungsvorrichtung verwendet werden, die einerseits zum Halten des Mikrofons und andererseits zur Verbindung der Mikrofonanschlüsse mit entsprechenden Kontakten der Leiterplatte dient.

Eine ähnliche Vorrichtung zum Halten und elektrischen Verbinden eines elektronischen Moduls ist ferner aus der Offenlegungsschrift EP 0 938 247 A1 bekannt. Bei dieser Vorrichtung wird das mit Elektroden versehene elektronische Modul mit einem Halteelement und einem elastischen Kontaktierungselement zu einem integralen Modul fest verbunden, das anschliessend mit einem Griff montiert werden kann.

Die oben beschriebenen Vorrichtungen sind zur Kontaktierung von Modulen, wie Schaltern, die beispielsweise am Rand der Leiterplatte in das Gehäuse eingefügt sind, jedoch nicht verwendbar. Zudem ist der Aufwand zur Verbindung der Anschlüsse des betreffenden Module über einen Verbindungskörpers der Halte- und Verbindungsvorrichtung auch bei dieser Vorrichtung verhältnismässig gross.

Der vorliegenden Erfindung liegt daher die Aufgabe zugrunde, eine Vorrichtung zur Befestigung und Kontaktierung von Modulen elektrischer Geräte zu schaffen, mittels der die beschriebenen Nachteile bekannter Lösungen vermieden werden können.

Diese Aufgabe wird mit einer Vorrichtung nach Anspruch 1 gelöst. Vorzugsweise Ausgestaltungen der Erfindung sind in weiteren Ansprüchen angegeben.

Die erfindungsgemässe Vorrichtung, die zur Befestigung und Kontaktierung von Modulen elektrischer Geräte dient, weist einen elastischen Körper auf, der zwischen einer einem ersten Gehäuseteil zugewandten Leiterplatte und einem einem zweiten Gehäuseteil zugewandten ersten Modul installiert wird, so dass die Leiterplatte und das erste Modul nach dem Verbinden der beiden Gehäuseteile elastisch gehalten sind. Erfindungsgemäss ist ein Kontaktierungselement vorgesehen, das zwischen den elastischen Körper und die Leiterplatte oder zwischen den elastischen Körper und das erste Modul einfügbar ist, welches Anschlusskontakte der Leiterplatte oder des ersten Moduls mit einem Anschlusskabel verbindet, das mit einem zweiten Modul, beispielsweise mit einem Schalter verbindbar ist.

Die Leiterplatte und das erste Modul, beispielsweise ein Lautsprecher oder ein Mikrofon, sind daher mit einfachen Massnahmen bequem montierbar und werden elastisch gehalten, so dass Verschiebungen oder Vibrationen verhindert und einwirkende Stösse gedämpft werden. Gleichzeitig werden einwandfreie Kontaktierungen zwischen Anschlüssen auf der Leiterplatte oder auf dem ersten Modul und dem Anschlusskabel gewährleistet. Eine Verbindung mittels Löten oder eine Durchführung elektrischer Leitungen durch den elastischen Körper, wie bei der in der Offenlegungsschrift EP 0 901 308 A2 gezeigten Vorrichtung, ist daher nicht notwendig.

Das anhand des Kontaktierungselements mit der Leiterplatte verbundene Anschlusskabel ist mit einem zweiten Modul, beispielsweise mit einem Schallwandler, einem Schalter, einer Tastatur oder einer Anzeigeeinheit verbunden, so dass nebst der Montage der Leiterplatte und des ersten Moduls gleichzeitig der Anschluss des zweiten Moduls an die Leiterplatte erfolgen kann.

In einer vorzugsweisen Ausgestaltung der Erfindung kann, anstelle des zweiten Moduls, das erste Modul, das vom elastischen Körper gehalten ist, mittels des Kontaktierungselements elektrisch mit dem Anschlusskabel verbunden werden.

Zur vereinfachten Montage weist der elastische Körper vorzugsweise wenigstens ein Befestigungselement auf, welches mit einem Halteelement des zweiten Gehäuseteils verbindbar ist.

Zur formschlüssigen seitlichen Fixierung der Leiterplatte und/oder des ersten Moduls ist im zugehörigen Gehäuseteil vorzugsweise wenigstens ein entsprechendes Formelement vorgesehen. Zur formschlüssigen seitlichen Fixierung des Kontaktierungselementes weist der elastische Körper vorzugsweise ebenfalls ein entsprechendes Formelement auf. Die Leiterplatte und die einzelnen Module können daher anhand der Befestigungsvorrichtung einfach und bequem montiert werden, ohne dass sie beim Schliessen der Gehäuseteile des Gerätes ihre Lage verändern oder gar heraus fallen können.

Zur Gewährleistung guter elektrischer Verbindungen wird der elastische Körper auf einer Seite vorzugsweise mit Nocken versehen, die den Anschlusskontakten des an der anderen Seite des elastischen Körpers anliegenden Kontaktierungselementes gegenüber liegen und diese somit an Kontakte andrücken, die auf der Leiterplatte vorgesehen sind.

Das Anschlusskabel ist vorzugsweise ein Flachbandkabel, in welches das Kontaktierungselement integriert ist. Der vorzugsweise aus einem Elastomer gefertigte elastischen Körper und das Kontaktierungselement, die vorzugsweise mittels eines Haftstoffs miteinander verbunden sind, sowie das Anschlusskabel können daher mit geringem Aufwand hergestellt werden.

Nachfolgend wird die Erfindung anhand von Zeichnungen näher erläutert. Dabei zeigt :
- Fig. 1: einen Gehäuseausschnitt eines Gerätes mit einer erfindungsgemässen Vorrichtung, die zur Befestigung und Kontaktierung von Modulen elektrischer Geräte dient;
- Fig. 2: die erfindungsgemässe mit einem Schalter verbundene Vorrichtung von Figur 1, die einen elastischen Körper und ein Kontaktierungselement aufweist, von oben gesehen;
- Fig. 3: die Vorrichtung von Figur 2 von unten gesehen;
- Fig. 4: den elastischen Körper von oben gesehen und
- Fig. 5: den elastischen Körper von unten gesehen.

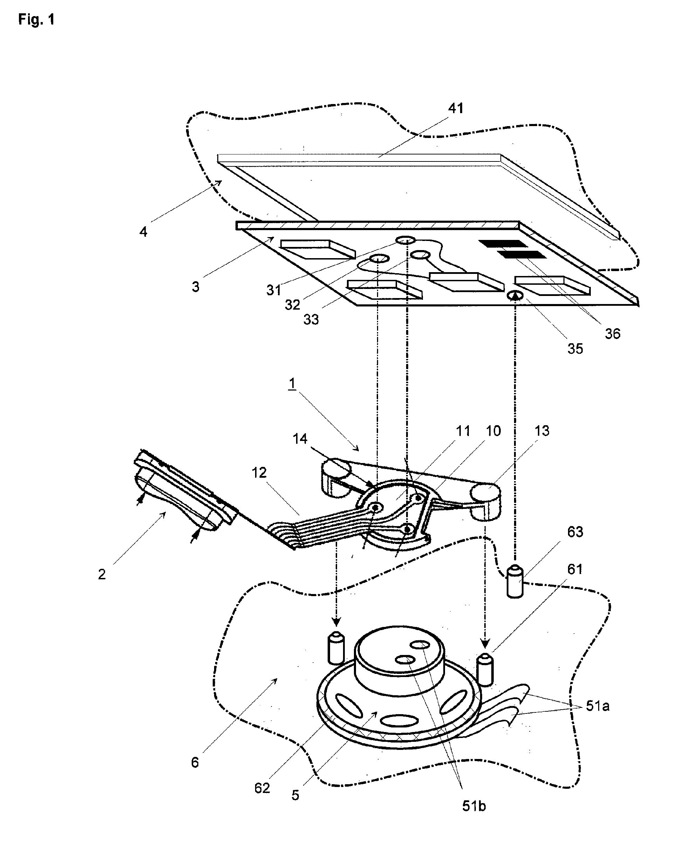

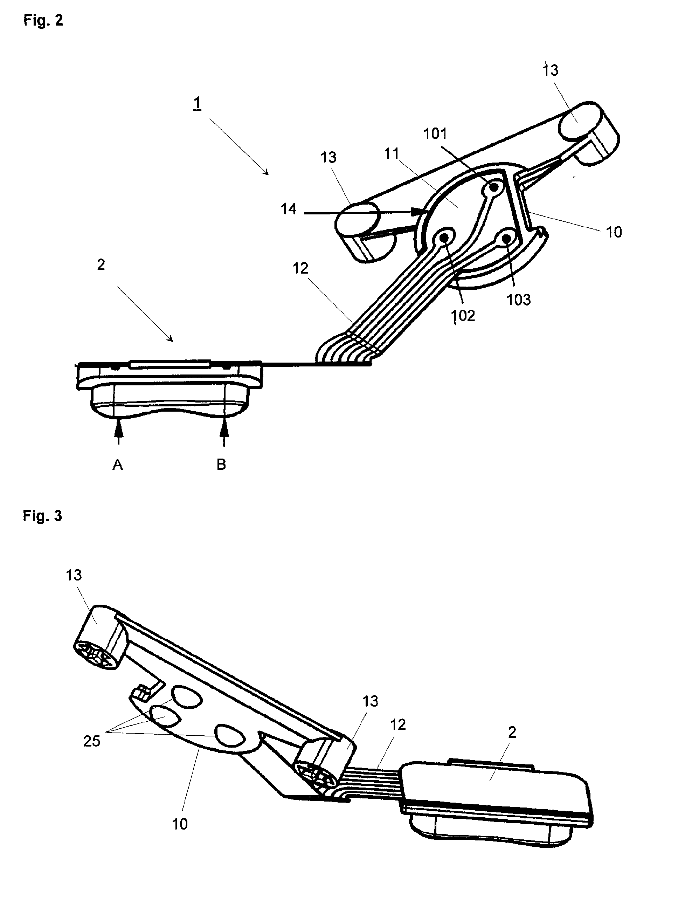

Figur 1 zeigt einen Gehäuseausschnitt mit einer erfindungsgemässen Vorrichtung 1, die zur Befestigung und Kontaktierung von Modulen 3, 5 eines elektrischen Gerätes dient, welches ein aus wenigstens zwei Teilen 4, 6 bestehendes Gehäuse aufweist. Die Vorrichtung 1 besteht aus einem elastischen Körper 10 und einem mit einem Anschlusskabel 12 verbundenen Kontaktierungselement 11, welches, wie in Figur 2 gezeigt, Anschlusskontakte 101, 102 und 103 aufweist. Das Anschlusskabel 12, das über die Anschlusskontakte 101, 102 und 103 an eine Leiterplatte 3 angeschlossen wird, ist mit einem Schalter 2 verbunden, der beispielsweise zum Ein- und Ausschalten des Gerätes dient.

Die Leiterplatte 3 und das erste Modul 5, in der beispielsweise gezeigten Ausgestaltung ein Lautsprecher, können einfach und bequem montiert werden. Gleichzeitig kann das zweite Modul, nämlich der Schalter 2, an die Leiterplatte 3 angeschlossen werden.

Dazu wird der Lautsprecher 5 in das zugehörige Gehäuseteil 6 eingelegt. Anschliessend wird das elastische, vorzugsweise aus einem Elastomer gefertigte elastische Element 10 auf den Lautsprecher 5 aufgesetzt. Auf der der Leiterplatte 3 zugewandten Seite des elastischen Elementes 10 wird das Kontaktierungselement 11 derart angeordnet, dass dessen Anschlusskontakte 101, 102 und 103 gegen die Leiterplatte 3 gerichtet sind.

In einer vorzugsweisen Ausgestaltung der Erfindung wird das Kontaktierungselement 11 bereits vorgängig mittels eines Haftstoffs mit dem elastischen Körper 10 verbunden, so dass diese beiden Teile 10, 11, wie in Figur 1 gezeigt, gleichzeitig positioniert werden können.

Anschliessend wird die Leiterplatte 3 derart aufgesetzt, dass darauf vorgesehene Anschlusskontakte 31, 32, 33 mit den Anschlusskontakten 101, 102, 103 des Kontaktierungselementes 11 verbunden werden.

Zum Abschliessen des Gerätes wird nun das zweite Gehäuseteil 4 aufgesetzt und mit dem ersten Gehäuseteil 6 verbunden, so dass die Leiterplatte 3 gegen das vom elastischen Körper 10 gehaltene Kontaktierungselement 11 angedrückt wird, wodurch eine stabile Befestigung der Leiterplatte 3 und des Lautsprechers 5 sowie eine gute elektrische Verbindung der Anschlusskontakte 31, 32, 33 bzw. 101, 102, 103 erzielt wird.

Zur gegenseitigen Befestigung der beiden Gehäuseteile 4, 6 weisen diese vorzugsweise Schnappverschlüsse auf, die beim Andrücken einrasten. Möglich ist natürlich auch die Verwendung von Montageschrauben.

Zur einfacheren Montage des Lautsprechers 5 und des elastischen Körpers 10, weist dieser in der beispielsweise gezeigten Ausführung zwei hülsenförmige Befestigungselemente 13 auf, welche mit kolbenförmigen Halteelementen 61 verbindbar sind, die auf dem ersten Gehäuseteil 6 angeordnet sind. Der montierte Lautsprecher 5 wird daher vom elastischen Körper 10 in der vorgesehenen Position gehalten.

Die kolbenförmigen Halteelemente 61 und/oder ein weiteres mit dem ersten Gehäuseteil 6 verbundenes Formelement 62 dienen vorzugsweise zum Positionieren und seitlichen formschlüssigen Halten des Lautsprechers 5.

Die Leiterplatte 3 weist, wie in Figur 1 gezeigt, vorzugsweise eine Öffnung 35 auf, durch die bei der Montage ein weiteres kolbenförmiges, mit dem ersten Gehäuseteil 61 verbundenes Halteelement 63 geführt wird, das die Leiterplatte 3 bei der Montage derart in eine Position führt und dort hält, dass die Anschlusskontakte 31, 32, 33 bzw. 101, 102, 103 der Leiterplatte 3 und des Kontaktierungselementes 11 präzise übereinander liegen. Zusätzlich oder alternativ dazu kann, wie in Figur 1 gezeigt, im zweiten Gehäuseteil 4 ein Formelement 41 vorgesehen sein, das zum formschlüssigen seitlichen Halten der Leiterplatte 3 geeignet ist.

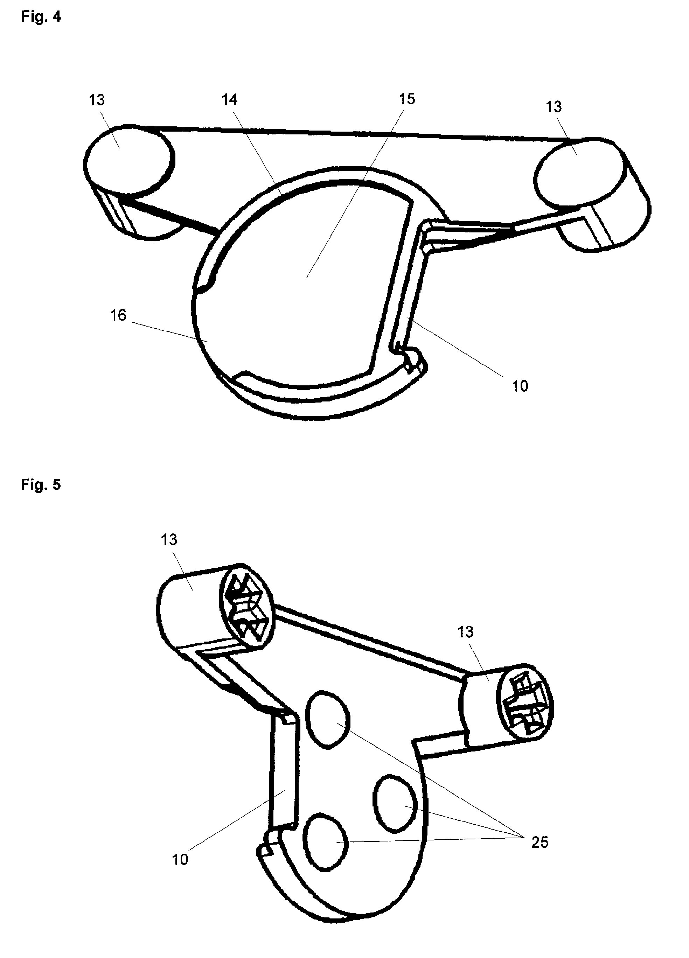

Aus Figur 2 und Figur 4 ist ersichtlich, dass der elastische Körper 10 zur Aufnahme des Kontaktierungselementes 11 eine Fläche 15 aufweist, innerhalb der das aufgesetzte Kontaktierungselement 11 mittels eines Formelementes 14 in einer dazu vorgesehenen Position seitlich formschlüssig in einer vorgesehenen Position gehalten wird. Durch Verwendung eines Haftstoffs wird das Kontaktierungselement 11 in dieser Position vorzugsweise fixiert.

Aus Figur 3 und Figur 5 ist ersichtlich, dass der elastische Körper 10 auf einer Seite zudem mit Nocken 25 versehen ist, die den Anschlusskontakten 102, 103, 104 des an der anderen Seite des elastischen Körpers 10 anliegenden Kontaktierungselementes 11 gegenüber liegen. Nach der Montage der Vorrichtung 1 sind die zumindest leicht hervorstehenden Nocken 25 auf dem Lautsprecher 5 abgestützt und drücken die gegenüberliegenden Anschlusskontakte 102, 103, 104 an die auf der Leiterplatte 3 vorgesehenen Anschlusskontakte 31, 32, 33 an, wodurch stets eine optimale Verbindung gewährleistet ist.

Aus den Figuren 1, 2 und 3 ist ferner ersichtlich, dass das Anschlusskabel 12 ein Flachbandkabel ist, in welches das Kontaktierungselement 11 derart integriert ist, dass beide Teile 11, 12 gleichzeitig und ohne Mehraufwand gefertigt werden können.

In den Figuren 1 bis 5 ist eine vorzugsweise Ausgestaltung und Verwendung der erfindungsgemässen Vorrichtung 1 gezeigt, mittels der, nebst einer Leiterplatte 3, ein Lautsprecher 5 in einem aus zwei Teilen bestehenden Gehäuse montiert und ein Schalter 2 über ein Anschlusskabel 12 mit der Leiterplatte 3 elektrisch verbunden werden kann. Anstelle des Lautsprechers 5 kann auch ein anderes Modul, beispielsweise ein Mikrofon, eine Tastatur oder eine Anzeige mittels der erfindungsgemässen Vorrichtung 1 befestigt werden.

Ebenso kann mittels des Anschlusskabels 12, anstelle des Schalters 2, ein weiteres Modul, beispielsweise ein eine Tastatur oder eine Anzeige mit der Leiterplatte 3 verbunden werden.

In Figur 1 ist gezeigt, dass die Leiterplatte 3 über das Kontaktierungselement 11 und das Anschlusskabel 12 mit einem Schalter 2 verbunden wird. Der Lautsprecher 5 wird über zwei Federkontakte 51a mit entsprechenden Kontakten 36 der Leiterplatte 3 verbunden.

In einer vorzugsweisen Ausgestaltung kann der Lautsprecher 5 jedoch auch mittels der erfindungsgemässen Vorrichtung 1 mit der Leiterplatte 3 verbunden werden. Dabei sind Anschlusskontakte 51b des Lautsprechers 5 an der Stelle vorzusehen, an der der elastische Körper 10 aufgesetzt wird. Das Kontaktierungselement 11 wird in diesem Fall zwischen dem elastischen Körper 10 und dem Lautsprecher 5 derart angeordnet, dass dessen Anschlusskontakte 101, 102, 103 an die Anschlusskontakte 51b des Lautsprechers 5 angepresst werden. Der Lautsprecher 5 kann auf diese Weise über das Anschlusskabel 12 bequem mit der Leiterplatte 3 verbunden werden.

## Patentansprüche

1. Vorrichtung (1) zur Befestigung und Kontaktierung von Modulen elektrischer Geräte mit einem elastischen Körper (10), der zwischen einer einem ersten Gehäuseteil (4) zugewandten Leiterplatte (3) und einem einem zweiten Gehäuseteil (6) zugewandten ersten Modul (5) installiert wird, so dass die Leiterplatte (3) und das erste Modul (5) nach dem Verbinden der beiden Gehäuseteile (4, 6) elastisch gehalten sind, **dadurch gekennzeichnet, dass** ein Kontaktierungselement (11) zwischen den elastischen Körper (10) und die Leiterplatte (3) oder zwischen den elastischen Körper (10) und das erste Modul (5) einfügbar ist, welches Anschlusskontakte (31, 32, 33, ...; 51b) der Leiterplatte (3) oder des ersten Moduls (5) mit einem Anschlusskabel (12) verbindet.

2. Vorrichtung nach Anspruch 1, **dadurch gekennzeichnet, dass** das mittels des Kontaktierungselements (11) elektrisch mit der Leiterplatte (3) verbundene Anschlusskabel (12) mit einem zweiten Modul (2) elektrisch verbunden ist.

3. Vorrichtung nach Anspruch 2, **dadurch gekennzeichnet, dass** das zweite Modul (2) ein Schallwandler, ein Mikrofon oder ein Lautsprecher, eine Tastatur oder eine Anzeigeeinheit ist.

4. Vorrichtung nach Anspruch 1, **dadurch gekennzeichnet, dass** das mittels des Kontaktierungselements (11) elektrisch mit dem ersten Modul (5) verbundene Anschlusskabel (12) mit der Leiterplatte (3) verbunden ist.

5. Vorrichtung nach einem der Ansprüche 1-4, **dadurch gekennzeichnet, dass** das erste Modul (5) ein Schallwandler, ein Mikrofon oder ein Lautsprecher, eine Tastatur oder eine Anzeigeeinheit ist.

6. Vorrichtung nach einem der Ansprüche 1-5, **dadurch gekennzeichnet, dass** der elastische Körper (10) wenigstens ein Befestigungselement (13) aufweist, welches mit einem Halteelement (61) des zweiten Gehäuseteils (6) verbindbar ist.

7. Vorrichtung nach einem der Ansprüche 1-6, **dadurch gekennzeichnet, dass** die Leiterplatte (3) und/oder das erste Modul (5) im zugehörigen Gehäuseteil (4; 6) seitlich mittels wenigstens eines Formelementes (41; 62) formschlüssig gehalten sind.

8. Vorrichtung nach einem der Ansprüche 1-7, **dadurch gekennzeichnet, dass** der elastische Körper (10) wenigstens ein Formelement (14) aufweist, mittels dessen das Kontaktierungselement (11) seitlich formschlüssig gehalten wird.

9. Vorrichtung nach einem der Ansprüche 1-8, **dadurch gekennzeichnet, dass** der elastische Körper (10) auf einer Seite mit Nocken (25) versehen ist, die den Anschlusskontakten (102, 103, 104) des an der anderen Seite des elastischen Körpers (10) anliegenden Kontaktierungselementes (11) gegenüber liegen.

10. Vorrichtung nach einem der Ansprüche 1-9, **dadurch gekennzeichnet, dass** das Anschlusskabel (12) ein Flachbandkabel ist, in welches das Kontaktierungselement (11) integriert ist.

11. Vorrichtung nach einem der Ansprüche 1-10, **dadurch gekennzeichnet, dass** das Kontaktierungselement (11) mittels eines Haftstoffs mit dem elastischen Körper (10) verbunden ist.

12. Vorrichtung nach einem der Ansprüche 1-11, **dadurch gekennzeichnet, dass** der elastische Körper 10 aus einem Elastomer gefertigt ist.

13. Vorrichtung nach einem der Ansprüche 1-12, **dadurch gekennzeichnet, dass** das zur Aufnahme des ersten Moduls (5) dienende Gehäuseteil (6) ein der Positionierung der Leiterplatte (3) dienendes Führungselement (63) aufweist.

14. Vorrichtung nach einem der Ansprüche 1-13, **dadurch gekennzeichnet, dass** die beiden Gehäuseteile (4, 6) mindestens einen Schnappverschluss aufweisen, der beim gegenseitigen Andrücken der beiden Gehäuseteile (4, 6) einrastet.
